# EUROPEAN PATENT SPECIFICATION

(11) **EP 4 062 444 B1**
(45) Date of publication and mention of the grant of the patent: **07.06.2023**
(21) Application number: 20848968.2
(22) Date of filing: 24.12.2020
(51) Int. Cl.: H01L 21/48, H01L 23/373

(54) **COOLING OF HIGH POWER DEVICES USING SELECTIVE PATTERNED DIAMOND SURFACE**
KÜHLEN VON HOCHLEISTUNGSGERÄTEN UNTER VERWENDUNG EINER SELEKTIV STRUKTURIERTEN DIAMANTOBERFLÄCHE
REFROIDISSEMENT DE DISPOSITIFS À HAUTE PUISSANCE À L'AIDE D'UNE SURFACE DE DIAMANT À MOTIFS SÉLECTIVE

(30) Priority: 25.12.2019 US 201962953558 P
(43) Date of publication of application: 28.09.2022
(73) Proprietor: Soreq Nuclear Research Center, 8180000 Yavne (IL)
(72) Inventor: SFEZ, Bruno, 9619032 Jerusalem (IL); STEINBERG, Oren, 8180000 Yavne (IL); GOUZMAN, Irina, 7645012 Rehovot (IL); BOLKER, Asaf, 7655984 Rehovot (IL)
(74) Representative: Jaeger, Michael David
(86) International application number: PCT/IB2020/062432
(87) International publication number: WO 2021/130716

(56) References cited:
- US-A1- 2014 110 722
- US-B1- 9 246 305
- KATSUMATA S ET AL: "Patterning of CVD diamond films by seeding and their field emission properties", DIAMOND AND RELATED MATERIALS, ELSEVIER SCIENCE PUBLISHERS, AMSTERDAM, NL, vol. 3, no. 11-12, 1 November 1994 (1994-11-01), pages 1296-1300, XP024178767, ISSN: 0925-9635, DOI: 10.1016/0925-9635(94)90141-4 [retrieved on 1994-11-01]

## Description

### FIELD OF THE INVENTION

The present invention relates to a method for efficiently extract heat from a semiconductor surface emitting device by employing a selective area growth of the semiconductor in diamond patterned structure.

### BACKGROUND OF THE INVENTION

Semiconductor surface emitting devices constitute a very important class of light emitting devices that comprise vertical cavity surface emitting lasers (VCSEL's), optically pumped disk lasers, micro-LED's and a plethora of mixed devices. Major advantages of such devices include high light extraction efficiency, built-in scalability, light mode quality inter alia. However, for high power applications, these devices lack proper heat extraction mechanism. This is due to their basic configuration: the physical contact between the device and the substrate is substantially smaller than for edge emitting devices. Moreover, the active region, where the heat is generated, is usually relatively far from the substrate, being separated from this substrate by a large number of layers, such as Bragg mirrors for example. Finally, since III-V crystals display relatively poor heat conductivity, heat is accumulated within the device and deteriorates its output (GaAs thermal conductivity coefficient is 0.55 W cm⁻¹°C⁻¹ compared to 1.3 W cm⁻¹°C⁻¹ for silicon).

This situation strongly hampers the development of high power devices and reduces the quality of the emitted light (mode distortion).

Currently, the state of the art for heat removal is either to mount them directly, or with a highly heat conductive heat-spreader, on a copper heat-sink.

Recently, to further improve heat extraction, new VECSEL designs have been proposed by employing two diamond heat-spreaders top and bottom (diamond-sandwich approach), either by diamond deposition or bonding. However, for both approaches, heat must diffuse through the whole structure in order to reach the bottom or the top of the device, from where it can be extracted.

For high power emission these approaches are not sufficient and more efficient heat extraction has to be provided.

US 9246305 B1 discloses a light emitting device with diamond layers integrated therein. The diamond is grown either directly on the semiconductor material comprising the light-emitting structure, on a nucleation layer deposited on the semiconductor material, or on a dielectric layer deposited on the semiconductor material before growth of the diamond layer.

### SUMMARY OF THE INVENTION

The present invention seeks to provide a method to embed semiconductor light emitting devices in a diamond surrounding so that each region of the device is in close contact with diamond. Since diamond is the best heat-spreader, this method leads to optimal heat extractior The present invention is given by claim 1. Preferred embodiments are given in the dependent claims.

### BRIEF DESCRIPTION OF THE DRAWINGS

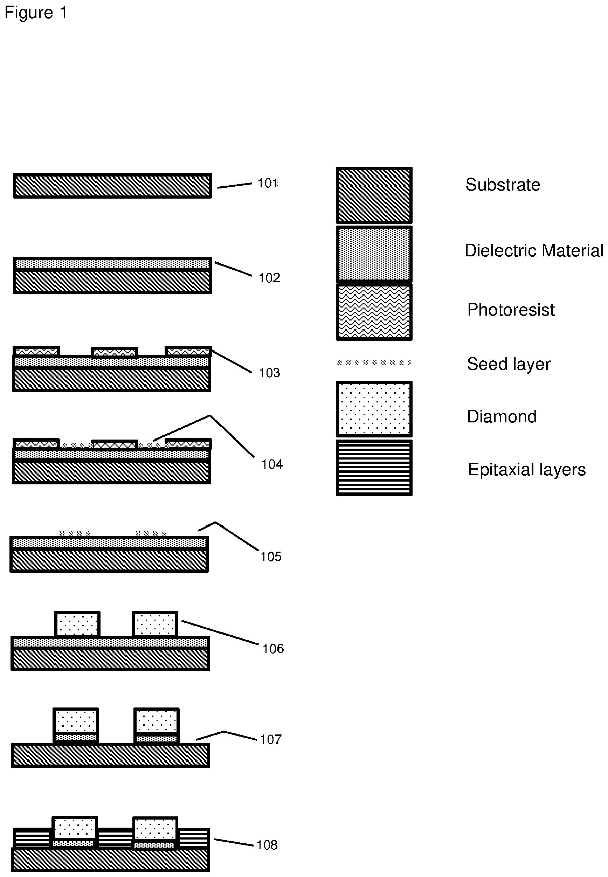

Fig. 1 is a simplified illustration of a process for diamond deposition on a semiconductor, in accordance with an embodiment of the invention. 101 is the semiconductor substrate, 102 after dielectric coating, 103 after dielectric material patterning, 104 after seeding, 105 after photoresist removal, 106 after CVD diamond growth, 107 after dielectric removal, and 108 after semiconductor layers' epitaxial growth.

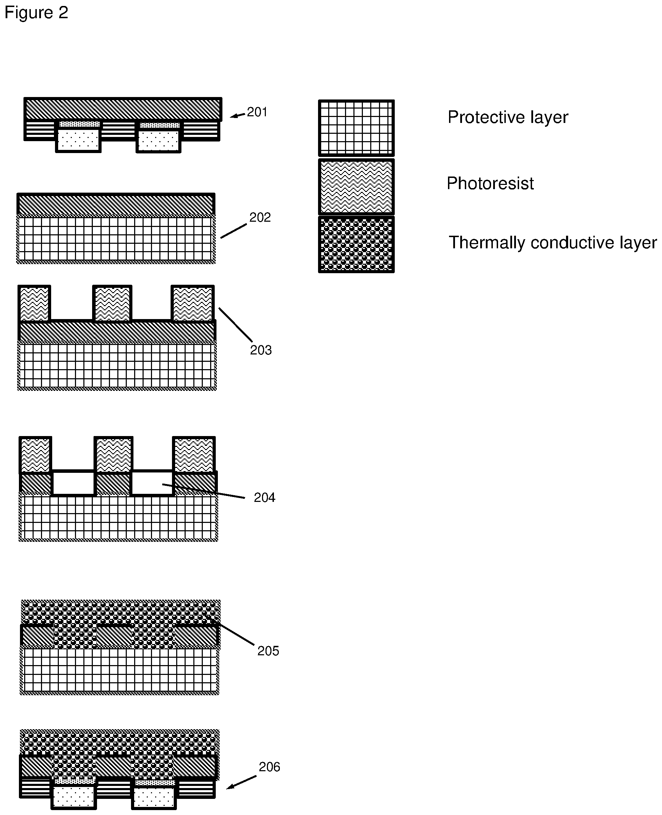

Fig. 2 is a simplified illustration of creating thermally-conductive vias or paths for thermally connecting the diamond covered areas of the device to a heat exchanger, in accordance with an embodiment of the invention.

### DETAILED DESCRIPTION OF THE INVENTION

The present invention provides an approach for producing a semiconductor surface emitting device with highly efficient heat extraction in order to enable high output, high quality power emitting device.

In order to do so, a diamond layer is grown on a semiconductor substrate. Reference is made to Figure 1, which describes a process for doing so, in accordance with an embodiment of the invention.

Starting from a semiconductor substrate 101, a dielectric material (such as silicon oxide, silicon nitride or any other material suitable for seeding with diamond particles) layer is deposited (102) and then a photoresist (PR) (or any other material that can be patterned by lithography) layer is deposited and patterned by lithography (103), determining areas with PR and areas without PR on the dielectric material surface. Next, a diamond seeding layer, such as diamond slurry, is deposited on the wafer (104). The photoresist is then removed, leaving a patterned diamond seeded surface on the wafer (105).

A diamond layer is deposited, for example by chemical vapor deposition technique (CVD). It should be noted that the diamond will grow preferentially on the regions that have been seeded. Residual growth might occur on the non-seeded regions, however with a very sparse density (islands-like growth), which is easy to remove in the following processes.

Deposition of diamond is done at high temperature range (>650 ⁰C), which is not applicable on a semiconductor device without protection, as the semiconductor (such as GaAs, InP, GaSb) surface thermally decomposes. Therefore, the dielectric layer has a dual purpose: prevent diamond growth on non-seeded regions on the wafer, and act as nucleation areas for diamond particles in the seeded areas (106).

Then, using an etching process, the dielectric layer in the non-seeded areas is removed, leaving an intact semiconductor surface. This process finally results in open semiconductor substrate selected areas surrounded by a diamond layer (107). It should be noted that thick diamond layers can be deposited in this way.

Following this, semiconductor layers are grown, for example using MOCVD (metal organic chemical vapor deposition) or MBE (molecular beam epitaxy) techniques (108). The growth is selective, being effective only in the selected areas where the semiconductor surface is open, free from diamond. The epitaxial layers are grown on the semiconductor surface (e.g. GaAs, InP, GaSb, GaN and alloys of these) and not on the diamond surface. According to the growth conditions, the epitaxial structure might be in contact with the diamond or very close. For thermal conduction, this is less critical than for electric conduction and the diamond layer which will act as a heat spread layer.

Another issue arises from the fact that the grown diamond layer surface may be hydrogen terminated, as a result of the hydrogen rich growth environment. The hydrogenation of the diamond surface may result in negative electron affinity, pulling the vacuum level below the conduction band minimum (up to -1.3 eV). This can result in charge transfer between the valence band of the diamond and conduction band of the device layer, thus turning the diamond into a P-type semiconductor and injecting unwanted electrons into the device layers. Possible methods to prevent this charge transfer include:
1. Surface oxidation, which will result in a diamond surface with a positive electron affinity of 1.7 eV, as shown by Ristein (J., Surface science of diamond: Familiar and amazing. Surface Science, 2006. 600(18): p. 3677-3689).
2. Deposition of a thin insulating layer with large band gap and sufficiently small electron affinity, such as SiO₂.

This technique enables a near-contact to full contact of the semiconductor side walls and the diamond layer which will act as a heat spread layer.

This technique enables a highly efficient heat extraction needed for high power devices, as heat generated in the active region of the device is very close to the diamond heat sink layer, resulting in a higher heat extraction efficiency compared to other techniques where the heat sink is located at a much higher distance from the active region.

The diamond layer is then connected to a heat exchanger or a thermoelectric cooler.

In order to remove heat efficiently, it is preferable to connect the diamond covered areas to a heat exchanger located at close proximity. A convenient way to do so is through vias filled with a thermally conducting material such as copper, indium or diamond.

The process is illustrated in Fig. 2:
After optionally thinning the wafer, starting from the grown device 201, a protective layer such as photoresist is deposited on the grown side of the wafer in order to protect the structures (202). Then a photoresist layer is deposited on the other side of the wafer and is patterned so as to leave holes that are correspondingly in front of the regions where the diamond has been grown previously (203). The wafer is then etched until the diamond layer is reached (204). The holes (204) are then filled with the thermally conducting material (205). The protective layer can then be removed (206). The wafer can then be cut into individual devices, and each device can be put in thermal contact with a passive or active heat sink.

It should be noted that the thermally conducting material can be a metal, such as copper. In such a case, this layer can be pattern by itself in order to provide electric contact to the devices.

## Claims

1. A method for selective deposition of diamond on a semiconductor substrate and depositing a semiconductor layer, comprising:
depositing a dielectric material layer on a semiconductor substrate;
depositing and patterning a photoresist layer on top of said dielectric material layer;
depositing a diamond seeding layer on said dielectric material layer;
removing said photoresist layer and leaving a patterned diamond seeded surface on said dielectric material layer;
depositing a diamond layer on said patterned diamond seeded surface;
removing said dielectric material from areas not seeded with said diamond seeding layer, leaving an area on said semiconductor substrate with no said diamond layer; and
depositing a semiconductor layer on said area.

2. The method according to claim 1, wherein said semiconductor layer is a III-V semiconductor layer.

3. The method according to claim 1, wherein said dielectric material comprises silicon oxide or silicon nitride.

4. The method according to claim 1, wherein said seeded surface comprises a diamond slurry.

5. The method according to claim 1, wherein said diamond layer is deposited using a chemical vapor deposition technique at a temperature above 650 °C.

6. The method according to claim 1, wherein vias are produced in the semiconductor substrate and filled with a thermally conducting material.

7. The method according to claim 6, wherein the vias are produced using the following steps:
covering a side of the semiconductor substrate that has said diamond layer with a protective layer;
depositing a photoresist layer on an opposite side of the semiconductor substrate;
patterning said photoresist layer so as to leave holes that are aligned with regions where diamond has been grown previously;
etching vias in the semiconductor substrate until the diamond layer is reached;
removing the photoresist layer;
filling said vias with a thermally conducting material; and
removing the protective layer.

8. The method according to claim 7, wherein the thermally conducting material comprises copper.

9. The method according to claim 7, wherein the thermally conducting material is patterned in order to provide electrical contacts.

## Patentansprüche

1. Verfahren zum selektiven Abscheiden von Diamant auf einem Halbleitersubstrat und Abscheiden einer Halbleiterschicht, mit:
Abscheiden einer dielektrischen Materialschicht auf einem Halbleitersubstrat;
Abscheiden und Strukturieren einer Photoresistschicht auf der dielektrischen Materialschicht;
Abscheiden einer Diamantkeimschicht auf der dielektrischen Materialschicht;
Entfernen der Photoresistschicht und Belassen einer strukturierten Diamantkeimoberfläche auf der dielektrischen Materialschicht;
Abscheiden einer Diamantschicht auf der strukturierten Diamantkeimoberfläche
Entfernen der dielektrischen Materialschicht von Bereichen, die nicht mit der Diamantkeimschicht gekeimt sind, wobei ein Bereich auf dem Halbleitersubstrat ohne die Diamantschicht zurückbleibt; und
Abscheiden einer Halbleiterschicht auf dem Bereich.

2. Verfahren nach Anspruch 1, wobei die Halbleiterschicht eine III-V-Halbleiterschicht ist.

3. Verfahren nach Anspruch 1, wobei das dielektrische Material Siliziumoxid oder Siliziumnitrid aufweist.

4. Verfahren nach Anspruch 1, wobei die Keimoberfläche eine Diamantsuspension aufweist.

5. Verfahren nach Anspruch 1, wobei die Diamantschicht durch Verwendung einer chemischen Gasphasenabscheidungstechnik bei einer Temperatur über 650°C abgeschieden wird.

6. Verfahren nach Anspruch 1, wobei Durchgänge in dem Halbleitersubstrat hergestellt und mit einem wärmeleitenden Material gefüllt werden.

7. Verfahren nach Anspruch 6, wobei die Durchgänge durch Verwendung der folgenden Schritte hergestellt werden:
Bedecken einer Seite des Halbleitersubstrats, welche die Diamantschicht aufweist, mit einer Schutzschicht;
Abscheiden einer Photoresistschicht auf einer entgegengesetzten Seite des Halbleitersubstrats;
Strukturieren der Photoresistschicht, um Löcher zu hinterlassen, die mit Bereichen ausgerichtet sind, in denen zuvor Diamant aufgewachsen ist;
Ätzen von Durchgängen in dem Halbleitersubstrat, bis die Diamantschicht erreicht ist;
Entfernen der Photoresistschicht;
Füllen der Durchgänge mit einem wärmeleitenden Material; und
Entfernen der Schutzschicht.

8. Verfahren nach Anspruch 7, wobei das wärmeleitende Material Kupfer aufweist.

9. Verfahren nach Anspruch 7, wobei das wärmeleitende Material strukturiert wird, um elektrische Kontakte bereitzustellen.

## Revendications

1. Procédé pour le dépôt sélectif de diamant sur un substrat de semi-conducteur et le dépôt d'une couche de semi-conducteur, comprenant :
le dépôt d'une couche de matériau diélectrique sur un substrat de semi-conducteur ;
le dépôt d'une couche de résine photosensible sur le dessus de ladite couche de matériau diélectrique, et la formation de motifs sur celle-ci ;
le dépôt d'une couche d'ensemencement de diamant sur ladite couche de matériau diélectrique ;
le retrait de ladite couche de résine photosensible, ce qui laisse une surface ensemencée de diamant à motifs sur ladite couche de matériau diélectrique ;
le dépôt d'une couche de diamant sur ladite surface à motifs d'ensemencement de diamant ;
le retrait dudit matériau diélectrique de zones non ensemencées avec ladite couche d'ensemencement de diamant, ce qui laisse une zone sur ledit substrat de semi-conducteur sans ladite couche de diamant ; et
le dépôt d'une couche de semi-conducteur sur ladite zone.

2. Procédé selon la revendication 1, dans lequel ladite couche de semi-conducteur est une couche de semi-conducteur III-V.

3. Procédé selon la revendication 1, dans lequel ledit matériau diélectrique comprend de l'oxyde de silicium ou du nitrure de silicium.

4. Procédé selon la revendication 1, dans lequel ladite surface ensemencée comprend une suspension de diamant.

5. Procédé selon la revendication 1, dans lequel ladite couche de diamant est déposée à l'aide d'une technique de dépôt chimique en phase vapeur à une température au-dessus de 650 °C.

6. Procédé selon la revendication 1, dans lequel des trous d'interconnexion sont produits dans le substrat de semi-conducteur et remplis avec un matériau thermiquement conducteur.

7. Procédé selon la revendication 6, dans lequel les trous d'interconnexion sont produits à l'aide des étapes suivantes :
le recouvrement d'un côté du substrat de semi-conducteur qui présente ladite couche de diamant avec une couche protectrice ;
le dépôt d'une couche de résine photosensible sur un côté opposé du substrat de semi-conducteur ;
la formation de motifs sur ladite couche de résine photosensible de façon à laisser des trous qui sont alignés avec des régions où du diamant a été mis en croissance précédemment ;
la gravure de trous d'interconnexion dans le substrat de semi-conducteur jusqu'à ce que la couche de diamant soit atteinte ;
le retrait de la couche de résine photosensible ;
le remplissage desdits trous d'interconnexion avec un matériau thermiquement conducteur ; et
le retrait de la couche protectrice.

8. Procédé selon la revendication 7, dans lequel le matériau thermiquement conducteur comprend du cuivre.

9. Procédé selon la revendication 7, dans lequel des motifs sont formés sur le matériau thermiquement conducteur afin de fournir des contacts électriques.
